# EUROPÄISCHE PATENTSCHRIFT

(11) **EP 1 368 505 B1**
(45) Veröffentlichungstag und Bekanntmachung des Hinweises auf die Patenterteilung: **19.09.2007**
(21) Anmeldenummer: 02711632.6
(22) Anmeldetag: 12.02.2002
(51) Int. Cl.: C23C 16/26, C01B 31/02, C23C 16/02

(54) **EIN CCVD-VERFAHREN ZUR HERSTELLUNG VON RÖHRENFÖRMIGEN KOHLENSTOFF-NANOFASERN**
A CCVD METHOD FOR PRODUCING TUBULAR CARBON NANOFIBERS
PROCEDE CCVD PERMETTANT LA PRODUCTION DE NANOFIBRES DE CARBONE TUBULAIRES

(30) Priorität: 16.03.2001 AT 4212001
(43) Veröffentlichungstag der Anmeldung: 10.12.2003
(73) Patentinhaber: Electrovac AG, 3400 Klosterneuburg (AT)
(72) Erfinder: MAUTHNER, Klaus, A-9131 Grafenstein (AT); LEISTER, Erich, A-1200 Wien (AT); HAMMEL, Ernst, A-1140 Wien (AT)
(74) Vertreter: Pawloy, Peter Michael
(86) Internationale Anmeldenummer: PCT/AT2002/000048
(87) Internationale Veröffentlichungsnummer: WO 2002/075018

(56) Entgegenhaltungen:
- EP-A- 1 061 041
- EP-A- 1 072 693
- EP-A- 1 129 990
- DE-A- 19 833 593
- GB-A- 824 090
- US-A- 3 617 343
- US-A- 3 892 890
- US-A- 5 079 040
- US-A- 5 780 101
- MAO J M ET AL: "GROWTH OF CARBON NANOTUBES ON COBALT DISILICIDE PRECIPITATES BY CHEMICAL VAPOR DEPOSITION" APPLIED PHYSICS LETTERS, AMERICAN INSTITUTE OF PHYSICS. NEW YORK, US, Bd. 72, Nr. 25, 22. Juni 1998 (1998-06-22), Seiten 3297-3299, XP000771133 ISSN: 0003-6951
- LEE C J ET AL: "SYNTHESIS OF UNIFORMLY DISTRIBUTED CARBON NANOTUBES ON A LARGE AREAOF SI SUBSTRATES BY THERMAL CHEMICAL VAPOR DEPOSITION" APPLIED PHYSICS LETTERS, AMERICAN INSTITUTE OF PHYSICS. NEW YORK, US, Bd. 75, Nr. 12, 20. September 1999 (1999-09-20), Seiten 1721-1723, XP000868314 ISSN: 0003-6951
- PATENT ABSTRACTS OF JAPAN vol. 015, no. 038 (C-0800), 30. Januar 1991 (1991-01-30) & JP 02 274881 A (C UYEMURA & CO LTD), 9. November 1990 (1990-11-09)

## Beschreibung

Die vorliegende Erfindung betrifft ein CCVD-Verfahren (Catalytical Chemical Vapour Deposition) zur Herstellung von röhrenförmigen Kohlenstoff-Nanofasern auf einem Träger durch katalytische Abscheidung von Kohlenstoff aus der Gasphase.

1991 entdeckte S. Iijima hochgradig geordnete röhrenförmige Kohlenstoffstrukturen in Ruß, der durch Lichtbogen-Entladung zwischen Kohlenstoffelektroden produziert wurde. Die Kenntnis über die vollkommene Struktur von Fullerenen führte ihn zu der Schlussfolgerung, dass diese Röhren aus zylinderförmigen, konzentrisch ineinander verschachtelten Graphitröhren um einen hohlen Kern bestehen, deren Enden durch Fullerenstrukturen in sich geschlossen sind. Ausgedehnte Untersuchungen der besagten Graphitstrukturen ergaben, dass zwei unterschiedliche Spezies vorlagen, nämlich Nanoröhrchen mit Mehrfachwänden (MWCNT), wie ursprünglich von Iijima berichtet, und Nanoröhrchen mit einfachen Wänden, welche etwa 1,5 nm im Durchmesser aufwiesen und eine Art röhrenförmig verlängerte Fullerene darstellen.

Die Perfektion dieses Materials bewog Forscher dessen Eigenschaften für mögliche praktische Anwendungen zu untersuchen. Aufgrund seiner wohlgeordneten Struktur zeigten Modellberechnungen in Übereinstimmung mit ersten Experimenten bald die überlegenen elektrischen, mechanischen und chemischen Eigenschaften von Kohlenstoff-Nanoröhren.

Wie schon in vielen Artikeln und Patenten beschrieben, will man röhrenförmige Kohlenstoff-Nanofasern, oft auch als Carbon-Nanotubes bezeichnet, einer Vielzahl technischer Anwendungen zuführen, wie z.B. als ultra-leichte Faserverstärkung in Verbundwerkstoffen, in Gleit- und Schmiermitteln oder als elektrisch/thermisch leitende Komponente in Kunststoffen.

Innerhalb der letzten 10 Jahre wurden eine Vielzahl von Syntheseverfahren zur Herstellung von Kohlenstoff-Nanoröhren vorgeschlagen. Es ist jedoch offensichtlich, dass die meisten Verfahren von Standardverfahren zur Herstellung von katalytisch aufgewachsenen Carbonfasern abgeleitet wurden. Insbesondere betraf dies die katalytische Fähigkeit einiger Übergangmetalle "faserförmigen Kohlenstoff" zu extrudieren, sobald sie in der Gas/Dampfphase existierenden Kohlenstoffresten ausgesetzt werden. So werden bereits in den 50er Jahren die Eisengruppenelemente Fe, Co und Ni als katalytisch aktiv beschrieben.

Es ist bereits lange bekannt, dass Nickel bei erhöhten Temperaturen das metastabilste Karbid M₃C der Eisengruppenelemente bildet und bei Kohlenstoffübersättigung Kohlenstoff-Nanofilamente ausscheidet. Daher wird Nickel, unter anderem auch in Form von Legierungen, als verbreitet gebräuchlicher Katalysator in der Carbon-Nanotube Synthese beschrieben.

Die US 3 892 890 A betrifft ein Verfahren zur Herstellung von auf einem Träger fest haftenden kristallinen Kohlenstoffbeschichtungen durch CVD (Chemical Vapour Deposition), wobei vor dem CVD-Verfahren eine Ni/P (4 - 12%-Masse an Phosphor) Beschichtung stromlos auf dem Träger abgeschieden wird.

Diese Patentschrift berichtet von der stromlosen elektrochemischen Abscheidung von (Ni,P)-Schichten im Schichtdickenbereich von 0,1 - 6 µm auf einem Eisen- oder mit Eisen beschichteten Träger, wobei in der abgeschiedenen Katalysatorbeschichtung aufgrund der Badzusammensetzung immer Phosphor miteingeschlossen wird. Dabei muss, um eine kristalline C-Schicht darauf abscheiden zu können, darauf geachtet werden, die aufgebrachte Katalysatorschicht nicht zu lange in nichtkohlenstoffhältiger Umgebung auf erhöhter Temperatur zu halten, um Legierungsbildung durch Diffusion und damit Deaktivierung des Katalysators zu verhindern. Die hier angesprochene Temperatur bewegt sich im Bereich zwischen 450 - 700°C, die maximale Temperzeit bei 600°C ist mit 10 Minuten unter einem Sauerstoffpartialdruck von 0,1 torr (13Pa) angegeben, wobei die Einwirkung von O₂ der Aktivierung dient. Es handelt sich somit hierbei um eine Aktivierung in oxydierender Atmosphäre. Um weiters Diffusionsvorgänge zwischen der Ni-Schicht und dem Fe-Substrat zu vermeiden, soll die CVD-Reaktionstemperatur in kürzester Zeit erreicht werden; dies bedeutet ein Aufheizen von Raumtemperatur auf Reaktionstemperatur in 5 Minuten. Über die nach dieser Patentschrift erzeugten kristallinen Kohlenstoffschichten gibt es keine näheren strukturellen Charakteristika, außer der Schichtdicke von wenigen µm. Es ist somit zumindest zweifelhaft, ob mit dem oberwähnten Verfahren gemäß der US 3 892 890 A röhrenförmige Kohlenstoff-Nanofasern erhalten werden können.

In der EP 1 061 041 A1 wird ein CVD-Prozess zur Herstellung von Kohlenstoff-Nanoröhren beschrieben. Gemäß dieser Veröffentlichung kommt hierfür ein Katalysator, der durch einen Ätzprozess hergestellt wird, zum Einsatz, der weiters eine Anzahl von nicht näher spezifizierten nanometergroßen katalytischen Partikeln aufweist. An solchen Partikeln können sich die Nanoröhren während des CVD-Prozesses bilden.

Mao et al. (Appl. Phys. Lett. (1998), 72(25); 3297-3299) beschreiben einen Katalysator zur Kohlenstoff-Nanoröhren-Produktion durch CVD, der durch die Implantierung von Co Silizium gebildet wird. Durch den Implantierung von Co entstehen Co-Prezipitate, die Nukleationszentren zur Nanoröhrenbildung darstellen.

Gemäß der vorliegenden Erfindung ist ein CCVD verfahren zur Herstellung von Röhrenförmigen Kohlenstoff-Nanofasern auf einem Träger dadurch gekennzeichnet, dass auf einem Träger vor Aufbringung der Katalysatorschicht durch Vorsehen von kristallographisch definierten Flächen mit Kanten und Spitzen zumindes stellenweise Zentren erhöhter Oberflächenenergie geschaffen werden, wobei die kristallographisch definierten Flächen durch kontrolliertes Abtragen von Teilen der Oberfläche des Trägers gebildet werden, und dann zumindes stellenweise eine stromlos abgeschiedene, auf Nickel oder Kobalt basierende Katalysatorschicht aufgebracht wird, welche vor der Abscheidung von Kohlenstoff aus der Gasphase in reduzierender Atmosphäre thermisch aktiviert wird. Überraschenderweise hat sich gezeigt, dass der Aktivierungsschritt in reduzierender Atmosphäre eine gegenüber dem aus der US 3 892 890 bekannten Stand der Technik wesentlich höhere Ausbeute an Kohlenstoff-Nanofasern ergibt, sodass das erfindungsgemäße verfahren für die großtechnische Erzeugung von röhrenförmigen Kohlenstoff-Nanofasern geeignet ist. Die Länge der Kohlenstoff-Nanofasern erreichte dabei in einigen Fällen sogar den mm-Bereich, die Gesamtausbeute an röhrenförmigen Kohlenstoff-Nanofasern in Bezug auf eingesetzten Kohlenstoff aus der Gasphase betrug unter nicht optimierten Bedingungen etwa 30%. Da die Ausbeute auch von der Ofenraumausnutzung abhängig ist (je mehr katalytisch aktive Fläche pro Raumelement in der Heißzone angeboten wird, desto besser ist die Gasausnutzung) wird zur Synthese großer, kommerziell verwertbarer Mengen an Kohlenstoff-Nanofasern vorgesehen, die Ofenheißzone mit Katalysator belegten Trägerplatten, welche im Abstand von 1 bis 3 cm gestapelt werden, zu beladen. Selbige Anordnung erlaubt bei optimaler Reaktionsdauer eine Gesamtausbeute an röhrenförmigen Kohlenstoff-Nanofasern in Bezug auf eingesetzten Kohlenstoff aus der Gasphase von bis zu 80%. Die optimale Reaktionsdauer ist eine empirische Größe welche durch i) die Beladungsdichte der Ofenheißzone mit Katalysator beschichteten Trägerplatten, ii) die Gasströmungsgeschwindigkeit, iii) die Temperatur und iv) die Konzentration der gasförmigen Kohlenstoffkomponente des/der den Reaktor durchströmenden Gases/Gasmischung bestimmt wird.

Gemäß einer bevorzugten Ausführungsform der vorliegenden Erfindung ist vorgesehen, dass die reduzierende Atmosphäre ein wasserstoffhältiges bzw. wasserstofflieferndes Gasgemisch umfasst. Als Gasgemische können hierbei beispielsweise H₂/Inertgas, Ammoniak und Ammoniak/Inertgas verwendet werden. Durch die Vorsehung einer reduzierenden, d.h. wasserstoffhältigen Atmosphäre kommt es zu einer weiteren Verbesserung der katalytischen Aktivität des erfindungsgemäß verwendeten katalytisch aktiven Materials. Ohne auf eine Theorie festgelegt zu sein, wird angenommen, dass durch die Anwesenheit von Wasserstoff, welcher sich bei erhöhter Temperatur in Übergangsmetallen löst, Diffusionsvorgänge im Festkörper erleichtert bzw. Restsauerstoffgehalte abgebaut werden. Derartige Diffusionsvorgänge können auch zu einer Verfeinerung der Korngrößen im Festkörper beitragen.

Vorzugsweise ist vorgesehen, dass die thermische Aktivierung bei einer Temperatur im Bereich von 350 - 700°C durchgeführt wird. Speziell in diesem Temperaturbereich wird die Aktivität des verwendeten Katalysators besonders erhöht. Höhere Temperaturen führen zu einer dichten Schicht und zu einem Zusammensintern der Katalysatorschicht, niedrigere Temperaturen verringern die Löslichkeit des Wasserstoffs im Metall und somit die Diffusionsvorgänge im Festkörper bzw. den Abbau von Restsauerstoffgehalten.

Der Träger weist zumindest stellenweise Zentren erhöhter Oberflächenenergie auf. Der artige Zentren werden durch kontrolliertes Abtragen von Teilen der Oberfläche geschaffen wobei durch Herausarbeiten von kristallographisch definierten Flächen Kanten und Spitzen vorgesehen werden, welche solche Zentren erhöhter Oberflächenenergie repräsentieren. Die stromlose Abscheidung der Katalysatorschicht erfolgt dann bevorzugt an diesen Zentren bzw. ist an diesen Zentren erst überhaupt möglich.

Gemäß einer bevorzugten Ausführungsform besteht der Träger zumindest stellenweise aus Al₂O₃ oder einer unter den gewählten Reaktionsbedingungen inerten Keramik, wobei diese Materialien gegebenenfalls auch zumindest stellenweise angebeizt bzw. angeätzt sind. Weiters kann der Träger zumindest stellenweise aus angeätztem Glas bzw. angeätzter Glaskeramik bestehen. Als Substratoberflächenbehandlungsmethoden stehen diverse chemische und physikalische Ätzmethoden zur Verfügung. Das gebräuchlichste Ätzmedium für Glas und Glaskeramik ist HF, welcher als wässerige Lösung oder in Form von Pasten angewendet wird. Wird Ätzpaste mittels Siebdruck auf den Träger aufgebracht, kann schon in diesem Schritt eine Mikrostrukturierung der Substratoberfläche erzielt werden, womit auf aufwendige Photolithographie verzichtet werden kann. Als Beispiele physikalischer Ätzmethoden, welche unter anderem speziell bei Keramiken anwendbar sind, sei auf Plasmaätzen oder RIE (Reactive Ion Etching) verwiesen. Bei Verwendung von Keramikschichten auf einem Glasträger ist es günstig, auf das Glas eine dünne Schichte Flussmittel (z.B. MgO) bzw. Haftvermittler aufzubringen, um während eines allfälligen Temperschrittes gute Schichthaftung zum isolierenden Trägerglas/Material zu gewährleisten.

Gemäß einer weiteren Ausführungsform des erfindungsgemäßen Verfahrens umfasst die Katalysatorschicht dabei eine stromlos abgeschiedene, phosphordotierte Nickelschicht, welche vorzugsweise 0,1 bis 12%-Masse an Phosphor aufweist. Der Phosphorgehalt kann dabei durch einen dem erfindungsgemäßen Aktivierungsschritt in reduzierender Atmosphäre vorgeschalteten Oxidationsschritt gezielt verringert bzw. auf einen gewünschten Wert eingestellt werden, wodurch eine erhöhte Porosität der Katalysatorschicht bzw. des Katalysatormaterials vorgesehen werden kann.

Besonders günstig ist ferner, wenn vor der stromlosen Abscheidung der Katalysatorschicht der Träger durch stromlose Abscheidung mit einer Palladiumbekeimung versehen wird, auf welche Bekeimung anschließend die auf Nickel bzw. Kobalt basierende Katalysatorschicht in Form einer Katalysator-Nanostruktur zur Vorsehung von Katalysator-Nanopartikel stromlos abgeschieden wird. Insbesondere auf elektrisch isolierende Substrate kann die erfindungsgemäß vorgesehene Katalysatorschicht zumeist nur nach vorangehender Pd-Bekeimung, welche ebenfalls stromlos aufgebracht wird, erfolgen. Derartig generierte Katalysator-Nanopartikel zeigen unerwartet hohe Aktivität für das Wachstum von röhrenförmigen Kohlenstoff-Nanofasern.

Wesentlich für die Aktivität des erfindungsgemäß verwendeten Katalysators ist neben der spezifischen Eigenschaft des Nickels bzw. Kobalts unter geeigneten Reaktionsbedingungen graphitische Kohlenstofffilamente auszuscheiden, insbesondere einerseits die Dotierung desselben mit Phosphor und andererseits gewünschtenfalls die der Abscheidung der Katalysatorschicht vorangehende Bekeimung des Trägermaterials mit Palladium.

Durch eine solche gezielte Bekeimung des Trägermaterials mit Palladium nach geeigneter Oberflächenbehandlung der Trägeroberfläche bzw. Oberflächenschicht des Trägers, ist es erstmals möglich, die für den Einsatz von erfindungsgemäß hergestellten röhrenförmigen Carbon-Nanotubes/Nanofasern als Feldelektronen-Emitter erforderlichen Abstände zwischen den einzelnen emittierenden Kohlenstoffstrukturen auf der Oberfläche des Trägers selbst vorzudefinieren. Wie bereits ausgeführt wird der mikro-/submikro-kristalline Aufbau des Trägermaterials vorzugsweise durch kontrolliertes Abtragen von Teilen der Oberfläche geschaffen, wobei durch Herausarbeiten von kristallographisch definierten Flächen Kanten und Spitzen vorgesehen werden, welche Zentren erhöhter Oberflächenenergie repräsentieren. An diesen Zentren wird dann aus einer Pd-Salzlösung das Pd nahezu ausschließlich abgeschieden, wobei die dadurch erhaltene Palladiumbekeimung Voraussetzung für die stromlose Aufbringung der auf Nickel bzw. Kobalt basierenden Katalysator-Nanostruktur ist. Ein weiterer Vorteil dieser Art der Katalysatoraufbringung liegt in der Steuerbarkeit der Katalysatorpartikelgröße in Abhängigkeit von der jeweiligen Abscheidedauer. Dies ist insoferne von großer Bedeutung, als der Carbon-Nanotube-/Faser-Durchmesser direkt von der Katalysatorpartikelgröße abhängt.

Als Kohlenstoffquelle für das hier beschriebene CCVD-Verfahren zur Herstellung von röhrenförmigen Kohlenstoff-Nanofasern durch katalytische Abscheidung von Kohlenstoff aus der Gasphase sind kohlenstoffhältige Gase bzw. kohlenstoffhältige Substanzen, welche in der Dampf-/Gasphase existieren, vorgesehen. Als günstig erweisen sich unter Umgebungsbedingungen gasförmige Kohlenwasserstoffe, bevorzugt solche, welche C-C-Mehrfachbindungen aufweisen. Um unter den gegebenen CCVD-Reaktionsbedingungen einer möglichen, der Natur des/der verwendeten Gases/Gasmischung zugrundeliegenden Autopyrrolyse entgegenzuwirken, ist es günstig, die kohlenstoffhältigen Substanzen mit im Stand der Technik gebräuchlichen Inertgasen (Ar, N₂, H₂, etc.) bzw. Gasen, welche im angegebenen Verfahren keine unerwünschten Nebenreaktionen hervorrufen (leichte Kohlenwasserstoffe, CO, CO₂, etc.), zu verdünnen.

Die Abbildungen zeigen:

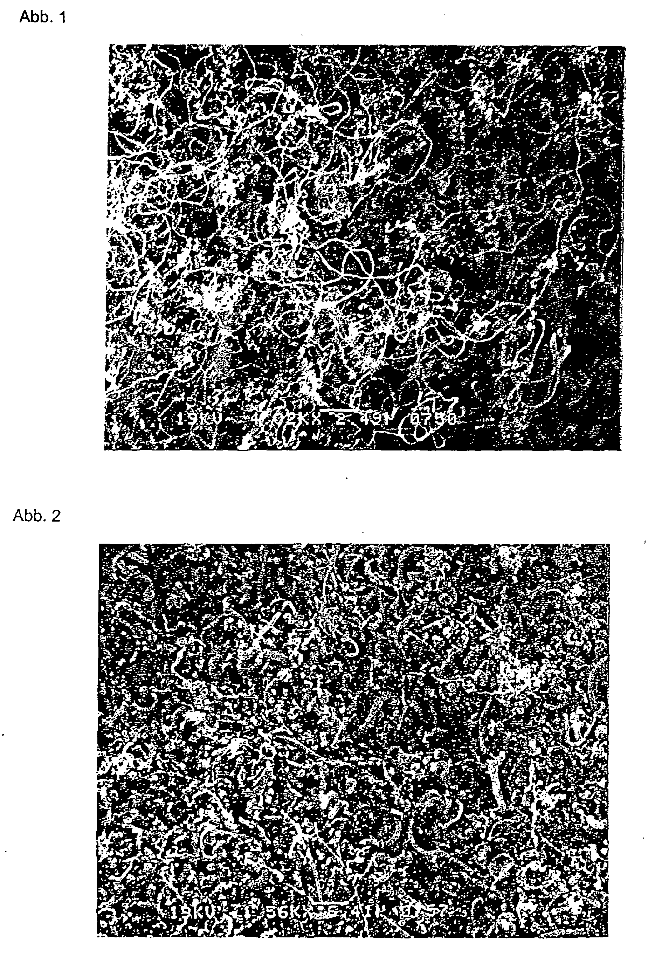

**Abb. 1:** SEM (Scanning Electron Microscope) Aufnahme von gemäß Beispiel 1 hergestellten röhrenförmigen Kohlenstoff-Nanofasern (30 Sekunden Pd-Bad und 30 Sekunden Ni-Bad), 80% der Fasern weisen einen Durchmesser zwischen 100 und 120 nm auf.
**Abb. 2:** SEM Aufnahme von gemäß Beispiel 1 hergestellten röhrenförmigen Kohlenstoff-Nanofasern (30 Sekunden Pd-Bad und 3 Minuten Ni-Bad), die Durchmesserverteilung der Nanofasern ist in diesem Beispiel flacher und im Bereich von 200 bis 700 nm.

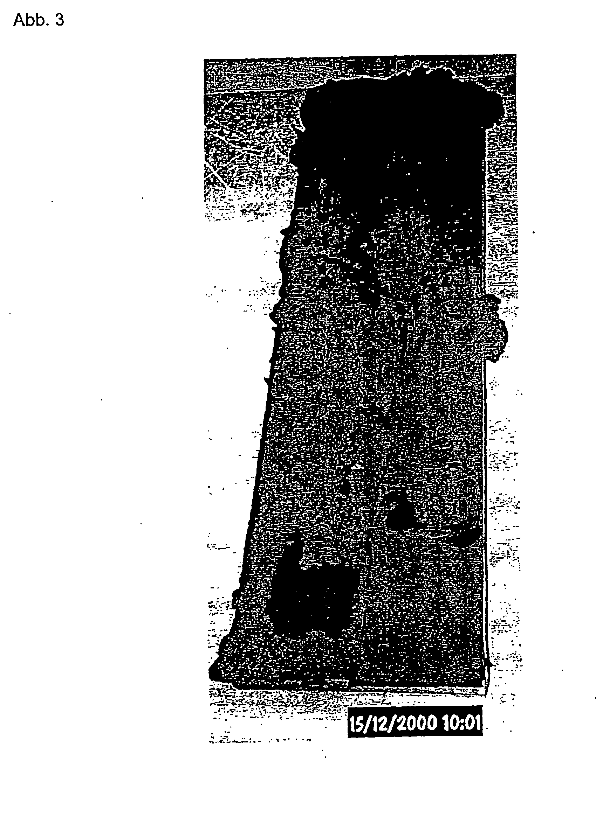

**Abb. 3:** Gezeigt wird ein veranschaulichendes Beispiel des erfindungsgemäßen Verfahrens (Beispiel 1) zur kommerziellen Massenproduktion von röhrenförmigen Kohlenstoff-Nanofasern. Acht mit Katalysator beschichtete Platten (250 x 100 x 1 mm) wurden in einer Stahltasse in den Ofen gemäß Beispiel 1 eingebracht und nach dem in Beispiel 1 angegebenen Verfahren mit röhrenförmigen Kohlenstoff-Nanofasern bewachsen. Die Ausbeute dieses Beispiels betrug 140 g (3,5 g pro 100 cm²).

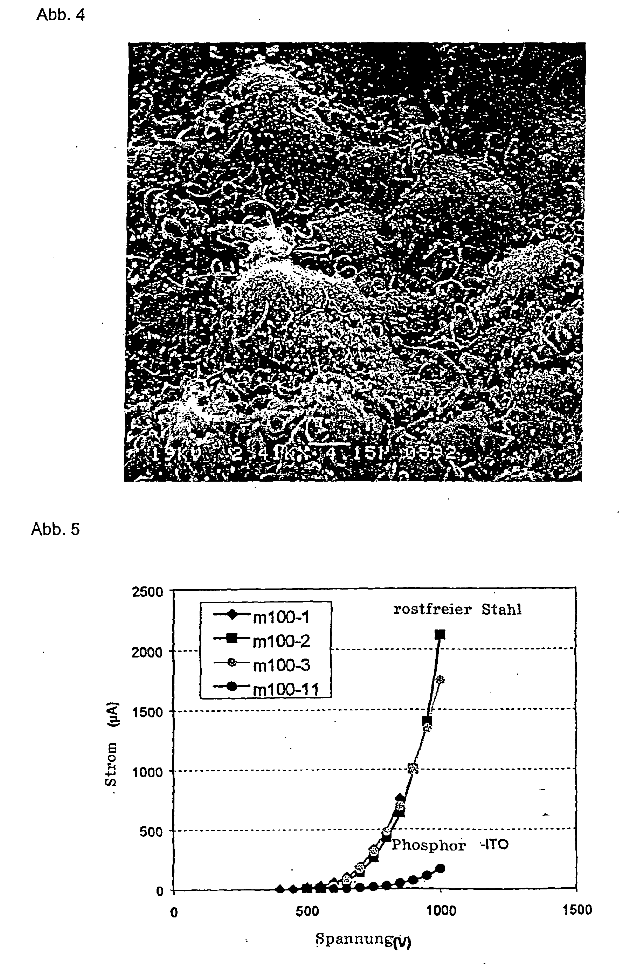

**Abb. 4:** SEM Aufnahme einer nach dem erfindungsgemäßen Verfahren (Beispiel 2) hergestellten Kohlenstoff-Nanofaser-Feldemissionskathode. Die röhrenförmigen Kohlenstoff-Nanofasern, obwohl in keiner Vorzugsrichtung orientiert, weisen genügend Abstand zwischen den einzelnen Faserenden auf, sodass bei Anlegen einer elektrischen Spannung die sich an den Spitzen ausbildenden elektrischen Felder nicht überlagern und damit eine gleichmäßige Elektronenemission über die gesamte Fläche ergeben.
**Abb. 5:** I/V (Strom/Spannung) Charakteristik einer Emissionskathode mit nach dem erfindungsgemäßen Verfahren (Beispiel 2) hergestellten röhrenförmigen Kohlenstoff-Nanofasern. Der Elektrodenabstand beträgt 150 µm, die Anode besteht aus poliertem Edelstahl und die emittierende Fläche beträgt 1 cm². Die flache Kurve wurde gegen eine mit blauem Phosphor/ITO beschichtete Lumineszenzanode erhalten.

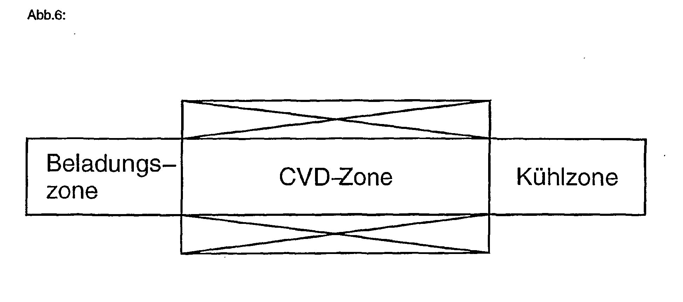

**Abb. 6:** Skizzierter Aufbau einer Ofenkonstruktion zur Herstellung von röhrenförmigen Kohlenstoff-Nanofasern im kontinuierlichen Betrieb. Beladungs- und Auskühlzone sind von der CVD-Zone abgeschottet und werden unter Inertgas gehalten. CVD-Gase (C-Precursor, H₂) werden nur in die CVD-Zone eingespeist.

Die vorliegende Erfindung wird nun anhand der nachfolgenden Beispiele, auf die sie jedoch nicht beschränkt sein soll, näher erläutert. Das verwendete Pd-Bad wird in Konzentratform von der Fa. Schloetter GmbH & Co. KG, D-73312 Geislingen, Deutschland, bezogen (Artikel Nummer: AN 180 120). Bei dem Ni-Bad handelt es sich um eine Eigenentwicklung der Electrovac GmbH auf Hypophosphitbasis, wobei der Phosphoranteil im Niederschlag in Abhängigkeit des pH-Wertes gesteuert werden kann.

### Beispiel 1:

Al₂O₃ Platten (180 x 125 x 0,65 mm) wurden in Dicklauge (NaOH 50%) bei 80°C angebeizt und mit Aqua dest. abgespült. Die derart vorbereiteten Platten wurden 30 Sekunden in ein kommerziell erhältliches Pd²⁺-Bad getaucht, wobei die Abscheidung von eng gesetzten metallischen Pd-Inseln an der angeätzten Keramikoberfläche durch H₂-Blasenentwicklung nach ca. 8 Sekunden beobachtet wurde. Auf die solcherart mit Pd vorbehandelten Stellen der Oberfläche wurde im Anschluss stromlos eine auf Nickel basierende, mit Phosphor dotierte Katalysatorschicht elektrochemisch aufgebracht. Der P-Gehalt im aufgebrachten Ni betrug in diesem Fall ca. 8%, die Schichtdicke wird über die Badverweilzeit gesteuert, welche je nach gewünschter Kohlenstoff-Nanofaser-Qualität und -Menge zwischen wenigen Sekunden und einigen Minuten betragen kann (vgl. Abb. 1,2). Es sei darauf verwiesen, dass es bei kürzeren Badverweilzeiten (bis zu 3 Minuten) zu keiner durchgehenden, homogenen Schichtbildung kommt. Die mit Katalysator versehenen Platten werden dann im Rohrofen (d = 230 mm, Heißzonenlänge = 800 mm) unter einem Argon-Wasserstoff-Gemisch auf 650°C aufgeheizt (Aufheizrate = 10°C/min) und bei dieser Temperatur im Ar/H₂-Strom 1,5 Stunden getempert. Nach dieser Zeit wurde ein Gasgemisch bestehend aus Ethylen, Wasserstoff und Argon im Drittelmix (Durchflussmenge - 1,5 Liter/min) für 1,5 Stunden in den Ofen geblasen. Nach Abkühlen auf Raumtemperatur unter Inertgas werden die faserbewachsenen Trägerplatten dem Reaktor entnommen (Abb. 3).

Die Ausbeuten an röhrenförmigen Kohlenstoff-Nanofasern hängen dramatisch von der aufgebrachten Katalysatormenge ab, welche auch die Durchmesserverteilung der erhaltenen Fasern beeinflusst. Mit Trägerplatten, auf welchen 30 Sekunden Pd und 3 Minuten Ni abgeschieden wurden, erzielt man 3-8 Gramm Nanofasern pro 100 cm² Substratfläche (Abb. 2). Reduziert man die Verweilzeit im Ni-Bad auf 30 Sekunden erhält man in der gleichen Zeit nur mehr 1-2 Gramm pro 100 cm² Fasermaterial, welches jedoch qualitativ höherwertiger ist (Abb. 1).

### Beispiel 2:

Glaskeramik (Foturan^{®}, Schott, DE) mit den Abmessungen 15 x 15 x 1 mm wird 15 Sekunden in verdünnter Flusssäure geätzt und anschließend 15 Sekunden im Pd-Bad und 30 Sekunden im Ni-Bad mit Katalysator belegt. Das Nanotube-Aufwachsen wurde in einem Rohrofen (Quarzrohr, d = 25 mm, 1 = 1000 mm, Heißzonenlänge = 400 mm) durchgeführt. Aufheizrate und Gaszusammensetzung wurde analog Beispiel 1 gewählt, lediglich Aktivierungszeit und CVD-Dauer auf 30 bzw. 15 Minuten verkürzt und die Temperatur auf 600°C angesetzt (Abb. 4,5).

## Patentansprüche

1. CCVD-Verfahren zur Herstellung von röhrenförmigen Kohlenstoff-Nanofasern auf einem Träger durch katalytische Abscheidung von Kohlenstoff aus der Gasphase, **dadurch gekennzeichnet, dass** auf einem Träger vor Aufbringung der Katalysatorschicht durch Vorsehen von kristallographisch definierten Flächen mit Kanten und Spitzen zumindest stellenweise Zentren erhöhter Oberflächenenergie geschaffen werden, wobei die kristallographisch definierten Flächen durch kontrolliertes Abtragen von Teilen der Oberfläche des Trägers gebildet werden, und dann zumindest stellenweise eine stromlos abgeschiedene, auf Nickel oder Kobalt basierende Katalysatorschicht aufgebracht wird, welche vor der Abscheidung von Kohlenstoff aus der Gasphase in reduzierender Atmosphäre thermisch aktiviert wird.

2. Verfahren nach Anspruch 1, **dadurch gekennzeichnet, dass** die reduzierende Atmosphäre ein wasserstoffhältiges bzw. wasserstofflieferndes Gasgemisch umfasst.

3. Verfahren nach Anspruch 1 oder 2, **dadurch gekennzeichnet, dass** die thermische Aktivierung bei einer Temperatur im Bereich von 350 - 700°C durchgeführt wird.

4. Verfahren nach einem der Ansprüche 1 bis 3, **dadurch gekennzeichnet, dass** der Träger zumindest stellenweise aus Al₂O₃ oder einer unter den Reaktionsbedingungen inerten Keramik besteht.

5. Verfahren nach Anspruch 4, **dadurch gekennzeichnet, dass** das Keramikmaterial zumindest stellenweise angebeizt bzw. angeätzt ist.

6. verfahren nach einem der Ansprüche 1 bis 3, **dadurch gekennzeichnet, dass** der Träger zumindest stellenweise aus angeätztem Glas bzw. angeätzter Glaskeramik besteht.

7. Verfahren nach einem der Ansprüche 1 bis 6, **dadurch gekennzeichnet, dass** die Katalysatorschicht eine stromlos abgeschiedene, phosphordotierte Nickelschicht umfasst.

8. Verfahren nach Anspruch 7, **dadurch gekennzeichnet, dass** die Nickelschicht 0,1 - 12%-Masse an Phosphor enthält.

9. Verfahren nach einem der Ansprüche 1 bis 8, **dadurch gekennzeichnet, dass** vor der zumindest stellenweisen, stromlosen Abscheidung der auf Nickel oder Kobalt basierenden Katalysatorschicht der Träger durch stromlose Abscheidung mit einer Palladiumbekeimung versehen wird, auf welche Bekeimung anschließend die auf Nickel bzw. Kobalt basierende Katalysatorschicht in Form einer Katalysator-Nanostruktur zur Vorsehung von Katalysator-Nanopartikel stromlos abgeschieden wird.

## Claims

1. A CCVD method for producing tubular carbon nano-fibres on a support by catalytic deposition of carbon from the gaseous phase, **characterised in that** before applying the catalyst layer, centres of increased surface energy are created on a support, at least in parts thereof, by providing crystallographically defined areas having edges and tips, wherein said crystallographically defined areas are formed by the controlled removal of parts of the surface of the support, and then a currentless deposited nickel- or cobalt-based catalyst layer is applied at least in parts thereof, which catalyst layer is thermally activated in a reducing atmosphere before carbon is deposited from the gaseous phase.

2. A method according to claim 1, **characterised in that** the reducing atmosphere comprises a hydrogen-containing or hydrogen-supplying gas mixture.

3. A method according to claim 1 or 2, **characterised in that** the thermal activation is carried out at a temperature ranging from 350 to 700°C.

4. A method according to any one of claims 1 to 3, **characterised in that** the support consists at least in parts thereof of Al₂O₃ or of a ceramics inert under the reaction conditions.

5. A method according to claim 4, **characterised in that** the ceramics material is pickled or etched at least in parts thereof.

6. A method according to any one of claims 1 to 3, **characterised in that** the support at least in parts thereof consists of etched glass, or etched glass ceramics, respectively.

7. A method according to any one of claims 1 to 6, **characterised in that** the catalyst layer comprises a currentless deposited, phosphorus-doped nickel layer.

8. A method according to claim 7, **characterised in that** the nickel layer contains from 0.1 to 12 % by mass of phosphorus.

9. A method according to any one of claims 1 to 8, **characterised in that** before the, at least partial, currentless deposition of the nickel- or cobalt-based catalyst layer, the support is provided with a palladium seeding by currentless deposition, the nickel- or cobalt-based catalyst layer subsequently being deposited, without using a current, on this seeding in the form of a catalyst nanostructure so as to provide catalyst nanoparticles.

## Revendications

1. Procédé CCVD pour la production de nanofibres de carbone tubulaires sur un support par dépôt catalytique de carbone depuis la phase gazeuse, **caractérisé en ce que** sur un support, avant le dépôt de la couche de catalyseur, par prévision de surfaces cristallographiquement définies avec des arêtes et des pointes, des centres d'énergie superficielle accrue sont créés au moins par endroits, sachant que les surfaces définies cristallographiquement sont formées par enlèvement contrôlé de parties de la surface du support, et **en ce qu'**ensuite, une couche de catalyseur déposée sans courant, à base de nickel ou de cobalt, est appliquée au moins par endroits, laquelle est activée thermiquement dans une atmosphère réductrice avant le dépôt du carbone depuis la phase gazeuse.

2. Procédé selon la revendication 1, **caractérisé en ce que** l'atmosphère réductrice comprend un mélange de gaz contenant de l'hydrogène, respectivement délivrant de l'hydrogène.

3. Procédé selon la revendication 1 ou 2, **caractérisé en ce que** l'activation thermique est effectuée à une température dans l'intervalle de 350 à 700 °C.

4. Procédé selon l'une quelconque des revendications 1 à 3, **caractérisé en ce que** le support consiste au moins par endroits en Al₂O₃ ou en une céramique inerte sous les conditions de réaction.

5. Procédé selon la revendication 4, **caractérisé en ce que** le matériau céramique est mordancé, respectivement attaqué chimiquement au moins par endroits.

6. Procédé selon l'une quelconque des revendications 1 à 3, **caractérisé en ce que** le support consiste au moins par endroits en verre attaqué chimiquement, respectivement en céramique de verre attaquée chimiquement.

7. Procédé selon l'une quelconque des revendications 1 à 6, **caractérisé en ce que** la couche de catalyseur comprend une couche de nickel dopée au phosphore, déposée sans courant.

8. Procédé selon la revendication 7, **caractérisé en ce que** la couche de nickel contient de 0,1 à 12 % en masse de phosphore.

9. Procédé selon l'une quelconque des revendications 1 à 8, **caractérisé en ce qu'**avant le dépôt, au moins par endroits, de la couche de catalyseur à base de nickel ou de cobalt, le support est doté par dépôt sans courant d'une nappe de germes de palladium, sur laquelle nappe de germes la couche de catalyseur à base de nickel, respectivement de cobalt, est ensuite déposée sous forme d'une nanostructure de catalyseur pour la prévision de nanoparticules de catalyseur.
